(19)

Europäisches
Patentamt
European
Patent Office
Office européen
des brevets

(11) **EP 2 903 167 B1**

(12) **EUROPEAN PATENT SPECIFICATION**

(45) Date of publication and mention
of the grant of the patent:
**07.08.2019 Bulletin 2019/32**

(51) Int Cl.:
**H03M 13/15** (2006.01) **H04L 1/00** (2006.01)

(21) Application number: **13840222.7**

(86) International application number:
**PCT/CN2013/084362**

(22) Date of filing: **26.09.2013**

(87) International publication number:
**WO 2014/048351 (03.04.2014 Gazette 2014/14)**

(54) **METHOD AND APPARATUS FOR FORWARD ERROR CORRECTION (FEC) CODING BASED ON TIME-DIVISION DUPLEX (TDD)**

VERFAHREN UND VORRICHTUNG ZUR VORWÄRTSFEHLERKORREKTUR-CODIERUNG (FEC) AUF DER BASIS VON ZEITDUPLEX (TDD)

PROCÉDÉ ET APPAREIL POUR LE CODAGE DE CORRECTION D'ERREURS SANS CIRCUIT DE RETOUR (FEC) À BASE DE DUPLEX À RÉPARTITION DANS LE TEMPS (TDD)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.09.2012 CN 201210370536**

(43) Date of publication of application:
**05.08.2015 Bulletin 2015/32**

(73) Proprietor: **Sanechips Technology Co., Ltd.**
**Shenzhen, Guangdong 518055 (CN)**

(72) Inventors:
• **ZENG, Jirui**
**Shenzhen**
**Guangdong 518057 (CN)**
• **WANG, Tong**
**Shenzhen**
**Guangdong 518057 (CN)**
• **WANG, Wenqing**
**Shenzhen**
**Guangdong 518057 (CN)**

(74) Representative: **Arnold + Siedsma**
**Bezuidenhoutseweg 57**
**2594 AC The Hague (NL)**

(56) References cited:
**CN-A- 101 622 791       CN-A- 101 686 416**
**CN-A- 101 686 416       CN-A- 101 981 831**
**CN-A- 102 231 631       CN-A- 102 231 631**
**JP-A- 2010 200 247       US-A- 5 983 388**
**US-A1- 2003 106 014     US-A1- 2005 286 521**
**US-A1- 2010 011 277**

• **TOMOYOSHI KATAOKA ET AL: "Design of a 43-Gb/s Line Terminal Based on Optical Transport Network System Architecture", JOURNAL OF LIGHTWAVE TECHNOLOGY, IEEE SERVICE CENTER, NEW YORK, NY, US, vol. 20, no. 12, December 2002 (2002-12), XP011064561, ISSN: 0733-8724**

## Description

### TECHNICAL FIELD

The disclosure relates to the technical field of communication, in particular to a time division multiplexing (TDM)-based Forward Error Correction (FEC) coding method and apparatus in the field of optical communication.

### BACKGROUND

In the field of optical communication, under the motivation of multi-service high-speed transmission, higher and higher requirements are made on a speed and transmission reliability of an optical transmission network. During optical communication, FEC is usually adopted to reduce an error code generated by the transmission of a signal through a channel to improve signal transmission quality and lower a requirement on the power of optical equipment. A Reed-Solomon (RS) code is one of frequently used coding modes. The RS code is valid in the correction of a random symbol error, a random burst error and the like, and has been widely applied to the fields of optical communication, digital televisions, data storage and the like.

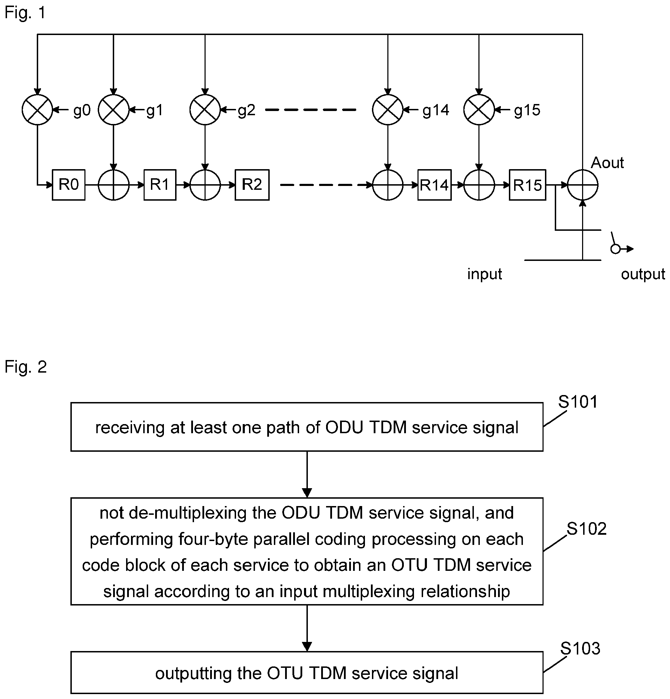

A serial coding method is usually adopted when the RS code is applied in a related art, code words are processed in series one by one in time sequence, and each code word consists of eight bits, that is, only eight bits can be processed in a clock cycle, as shown in Fig. 1. The method is low in coding efficiency and data throughput and unfavourable for increasing the whole system transmission rate, and a requirement of high-speed transmission on data processing cannot be met.

A double-code word parallel processing method is also adopted in the related art, wherein two code words can be processed in parallel in each clock cycle; although the coding efficiency and the system data throughput are improved to a certain extent, processing capability is still required to be further improved for the high-speed transmission of a service. Moreover, the coding efficiency and the system data throughput are improved with higher resource consumption in the method, and the greatest disadvantage of the method is that multiple groups of coders are required to run in parallel for the simultaneous processing of multiple services, that is, each service corresponds to a group of coders, so that the resource consumption is increased.

### SUMMARY

A main purpose of the embodiments of the disclosure is to provide a TDM-based FEC coding method and apparatus, so as to improve system transmission efficiency and reduce resource consumption.

The features of the TDM-based FEC coding method and apparatus according to the present disclosure are defined in the independent claims, and the preferable features according to the present disclosure are defined in the dependent claims.

According to the TDM-based FEC coding method and apparatus disclosed by the embodiments of the disclosure, at least one path of received ODU TDM service signal is not de-multiplexed, and each code block of each service is subjected to the four-byte parallel coding processing according to the input multiplexing relationship, so that coding efficiency, system transmission efficiency and network data transmission processing capability are greatly improved, and for the multiplexing data processing of multiple services, processing such as data collection before coding and output smoothing after coding is not required, and coding operation can be directly performed according to an input service multiplexing characteristic. In addition, the same set of coding circuit is multiplexed by each input service, and compared with a manner that each service corresponds to a group of coders, such a manner has the advantages that coding circuit resource consumption is greatly reduced, and circuit power consumption is lowered. Moreover, when the number of input services increases, the processing circuit can be automatically adapted to a preceding transmission bandwidth, and when a path of service is added to current paths of services, it is only necessary to add a group of registers or cache circuits to the corresponding circuit, which generates low resource consumption, and greatly saves operational circuit resources. Furthermore, the mixed input of various types of services can simultaneously support the coding operation of each mixed service.

### BRIEF DESCRIPTION OF THE DRAWINGS

Fig. 1 is a structure diagram of an RS serial coder in a related art;

Fig. 2 is a first flowchart of a TDM-based FEC coding method according to an embodiment of the disclosure;

Fig. 3a is a matrix diagram of a four-byte RS parallel coder according to an embodiment of the disclosure;

Fig. 3b is a data registration circuit diagram of a four-byte RS parallel coder according to an embodiment of the disclosure;

Fig. 3c is a structure diagram of an operation part of a four-byte RS parallel coder according to an embodiment of the disclosure;

Fig. 3d is a structure diagram of a logic module of a four-byte RS parallel coder according to an embodiment of the disclosure;

Fig. 4 is a flowchart of obtaining an OTU TDM service signal according to an embodiment of the disclosure;

Fig. 5 is a second flowchart of a TDM-based FEC coding method according to an embodiment of the disclosure;

Fig. 6a is an interleaving diagram of 16 code blocks in an OTU frame structure according to an embodiment of the disclosure;

Fig. 6b is an inner structure diagram of a TDM sub-coder according to an embodiment of the disclosure;

Fig. 6c is a structure diagram of a FIFO circuit of a TDM sub-coder according to an embodiment of the disclosure;

Fig. 6d is an illustration diagram of a working time sequence of a TDM sub-coder according to an embodiment of the disclosure;

Fig. 7 is a first structure diagram of a TDM-based FEC coding apparatus according to an embodiment of the disclosure;

Fig. 8 is a structure diagram of a coding module of a TDM-based FEC coding apparatus according to an embodiment of the disclosure; and

Fig. 9 is a second structure diagram of a TDM-based FEC coding apparatus according to an embodiment of the disclosure.

## DETAILED DESCRIPTION

Technical solutions of the embodiments of the disclosure are mainly as follows: one or more paths of received ODU TDM service signals are not de-multiplexed, and each code block of each service is subjected to four-byte parallel coding processing according to an input multiplexing relationship, so that coding efficiency, system transmission efficiency and network data transmission processing capability can be greatly improved, and for the multiplexing data processing of multiple services, processing such as data collection before coding and output smoothing after coding is not required, and coding operation can be directly performed according to an input service multiplexing characteristic. Moreover, the same set of coding circuit is multiplexed by each input service, so that coding circuit resource consumption is reduced, and circuit power consumption is lowered.

Fig. 2 is a first flowchart of a TDM-based FEC coding method according to an embodiment of the disclosure, and as shown in Fig. 2, the method includes the following steps:

Step 101: at least one path of ODU TDM service signal is received;
wherein of the received ODU TDM service signals (called service signal hereinafter for short) may be one-path signals or multi-path signals; if the service signals are multi-path signals, types of the multiple paths of service signals may be the same, or partially the same or completely different, and when the multiple paths of service signals are processed, subsequent processing is sequentially performed according to clock cycles set by a system;
in the embodiment, the ODU TDM service signal may specifically be a 512-bit TDM service signal. During subsequent coding processing, the 512-bit TDM service signal is divided into 16 paths, and each path is subjected to four-byte parallel coding processing;

Step 102: the ODU TDM service signal is not de-multiplexed, and four-byte parallel coding processing is performed on each code block of each service to obtain an OTU TDM service signal according to an input multiplexing relationship; and

Step 103: the OTU TDM service signal is output.

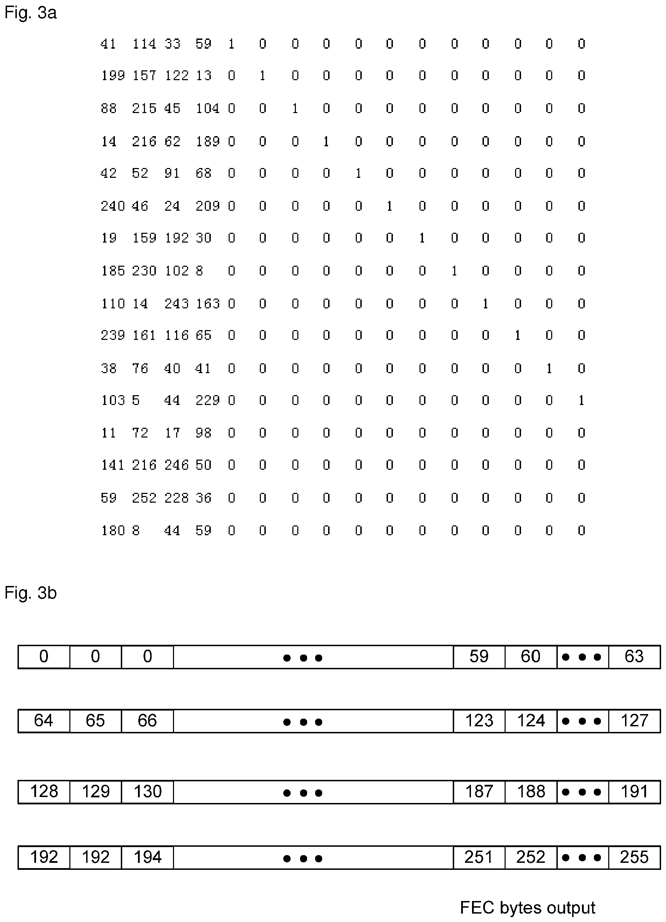

The received path of 512-bit TDM service signal is taken as an example, and in the embodiment, the four-byte parallel RS coding of the 512-bit TDM service signal can be implemented. Fig. 3a is a matrix diagram of a four-byte RS parallel coder according to an embodiment of the disclosure. As shown in Fig. 3a, the matrix is also called a parameter matrix, and for an RS (255, 239), 239 clock cycles are needed to finish coding to obtain check information if a serial coding manner is adopted, while only 60 clock cycles are needed if a four-byte parallel coding processing manner is adopted, thus the coding efficiency is improved by four times.

During processing, the received 512-bit TDM service signal is divided into two paths of data; and the first path of data is transmitted into a FIFO circuit, and the second path of data is configured to calculate coded information as operational data, and is transmitted into a coder for four-byte parallel coding processing.

The path of data transmitted into the FIFO circuit is configured as original data, and is subjected to delaying processing to obtain a delayed ODU TDM service signal; and the delaying processing through the FIFO is to keep the path of data aligned with the check information output by the coder in time sequence.

Before the second path of data is transmitted into the coder, the second path of data is needed to be interleaved, and the interleaved data is transmitted into the coder and subjected to four-byte parallel coding processing to obtain coded check information; and the coded check information is de-interleaved.

Finally, the de-interleaved check information and the delayed ODU TDM service signal form the OTU TDM service signal for output.

In a coding processing process, a preset four-byte RS parallel coding iterative formula is adopted in the coder, as follows:

$$
r_j' = \begin{cases} \sum_{i=0}^{3} g_{15-j,i} \otimes (u_i \oplus r_{15-i}), \ j = 0,1,2,3 \\ (\sum_{i=0}^{3} g_{15-j,i} \otimes (u_i \oplus r_{15-i})) \oplus r_{j-4}, \ j = 4,5,\cdots,15 \end{cases}
$$

$$(1)$$

Formula (1) is a coder parameter calculation formula deduced according to a finite field generation polynomial, the formula determines the operation complexity of a finite field algorithm, and if the operation complexity is higher, required resource cost is higher.

In addition, Fig. 3b is a data registration circuit diagram of a four-byte RS parallel coder according to an embodiment of the disclosure, and as shown in Fig. 3b, an OTU frame structure includes 4,080 columns in each row, wherein information to be coded occupies 3,824 columns and includes 16 code blocks, and it takes 239 clock cycles to finish coding of each code block when the serial coding manner is adopted, while it takes only 60 clock cycles to finish coding when the four-byte parallel coding manner according to the embodiment is adopted. Totally 240 columns can be processed in the 60 cycles, and is one more than the columns processed by the 239 cycles, therefore, zero can be padded at the beginning of each row during coding processing, that is, the information to be coded can also be subjected to zero padding processing before the information to be coded is interleaved, and then corresponding zero suppression processing is required during the subsequent coding processing of the information to be coded in the coder; and the zero padding processing of the information to be coded can be avoided before the information to be coded is interleaved, and then corresponding zero suppression processing is not required during the subsequent coding processing of the information to be coded in the coder.

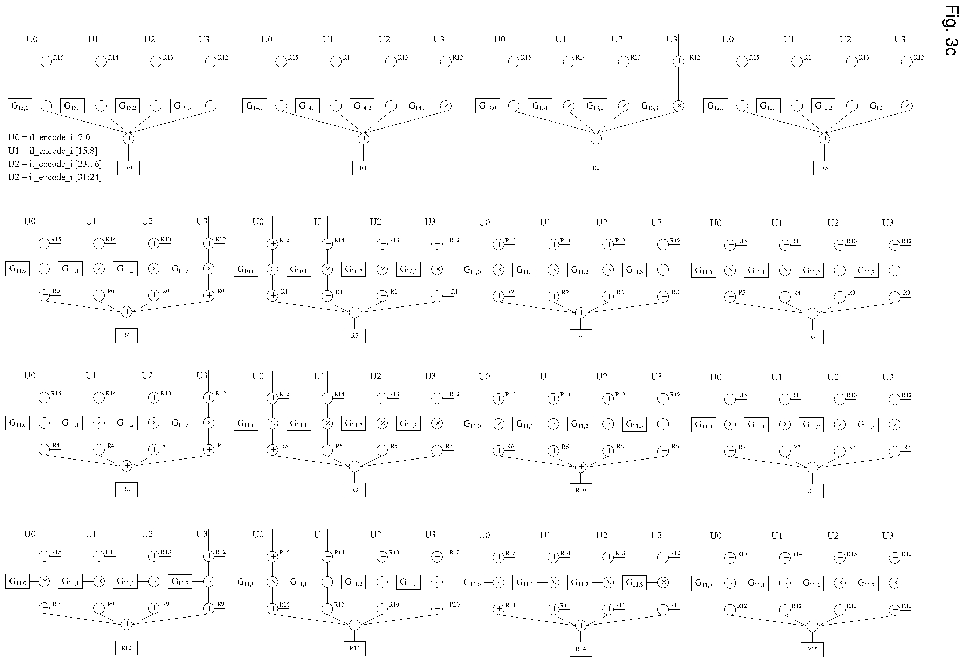

The structure of an operation part of the four-byte RS parallel coder adopted in the embodiment is shown in Fig. 3c.

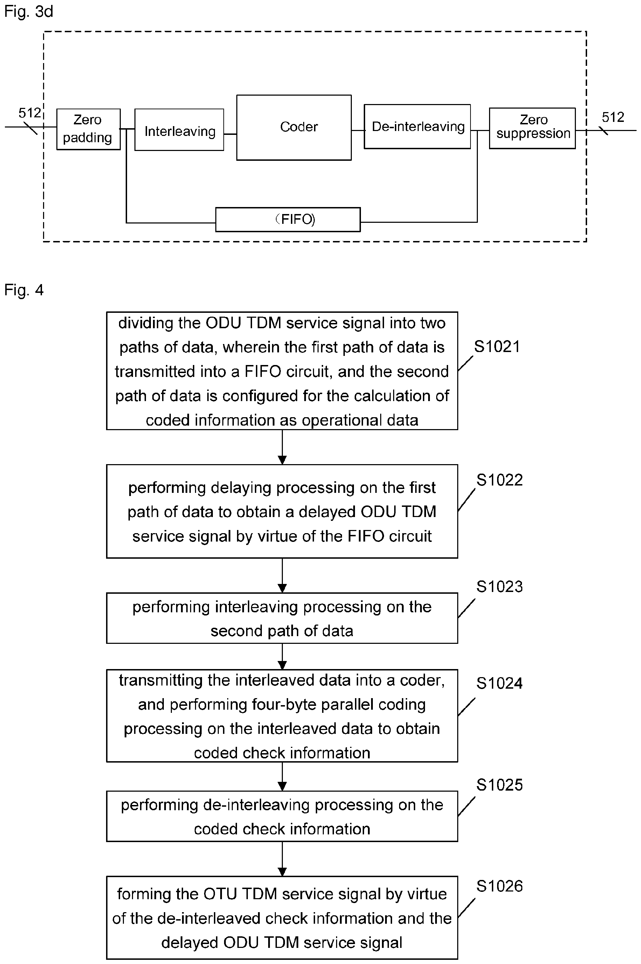

The structure of a logic module of the four-byte RS parallel coder adopted in the embodiment is shown in Fig. 3d.

Fig. 4 is a flowchart of obtaining an OTU TDM service signal according to an embodiment of the disclosure. As shown in Fig. 4, the case that the ODU TDM service signal is a 512-bit TDM service signal is taken as an example, and Step 102 of not de-multiplexing the ODU TDM service signal, and performing four-byte parallel coding processing on each code block of each service to obtain an OTU TDM service signal according to an input multiplexing relationship includes that:

Step 1021: the ODU TDM service signal is divided into two paths of data, wherein the first path of data is transmitted into a FIFO circuit, and the second path of data is taken as operational data to calculate coded information;

Step 1022: delaying processing is performed on the first path of data to obtain a delayed ODU TDM service signal by virtue of the FIFO circuit;

Step 1023: interleaving processing is performed on the second path of data;

Step 1024: the interleaved data is transmitted into a coder, and four-byte parallel coding processing is performed to obtain coded check information;

Step 1025: de-interleaving processing is performed on the coded check information; and

Step 1026: the OTU TDM service signal is formed by the de-interleaved check information and the delayed ODU TDM service signal.

The received path of 512-bit TDM service signal is taken as an example, and a process of transmitting the interleaved data into the coder and performing four-byte parallel coding processing to obtain the coded check information includes: transmitting the interleaved data into 16 sub-coders respectively; performing four-byte data parallel coding in each sub-coder; and after coding is finished, if check information valid signals transmitted by the 16 sub-coders are consistent and meet an output condition of a current service, extracting the check information of the service from a check register group of the sub-coders of the current service for output.

When TDM service signals of multiple paths of ODU services are sequentially received according to preset clock cycles, the process of transmitting the interleaved data into the coder and performing four-byte parallel coding processing to obtain the coded check information includes: in a current clock cycle, transmitting the interleaved data of the current service into the 16 sub-coders respectively; performing four-byte data parallel coding in each sub-coder; when the next clock cycle comes, judging whether a coding process of the current service is ended or not; transferring a coding result of the current service into the check register group of the current service if the coding process of the current service is ended, otherwise, storing an intermediate result of data operation of the current service into a cache register group of the current service, and continuing coding operation when the next clock cycle of the current service comes; simultaneously performing operation on the next service; and for each path of ODU TDM service signal, after coding is finished, if the check information valid signals transmitted by the 16 sub-coders are consistent and meet the output condition of the current service, extracting the check information of the service from the check register group of the current service for output.

Compared with the related art, the embodiment has the advantages that by the solution, single-service and multi-service RS coding processes can be implemented with low resource consumption, resources can be more remarkably saved if there are more multiplexing services, and the static power consumption of a chip is also lowered; in addition, the coding processing in the embodiment has the characteristic of high data throughput, the data throughput is 64 times that of a conventional coder, and network data transmission processing capability is improved; the number of the clock cycles required by coding is reduced to 1/4 of that of a serial coder; and when the number of the multiplexing services increases, the coding circuit is easy to expand, the concern about insufficient processing bandwidth is eliminated, and the resource cost is extremely low.

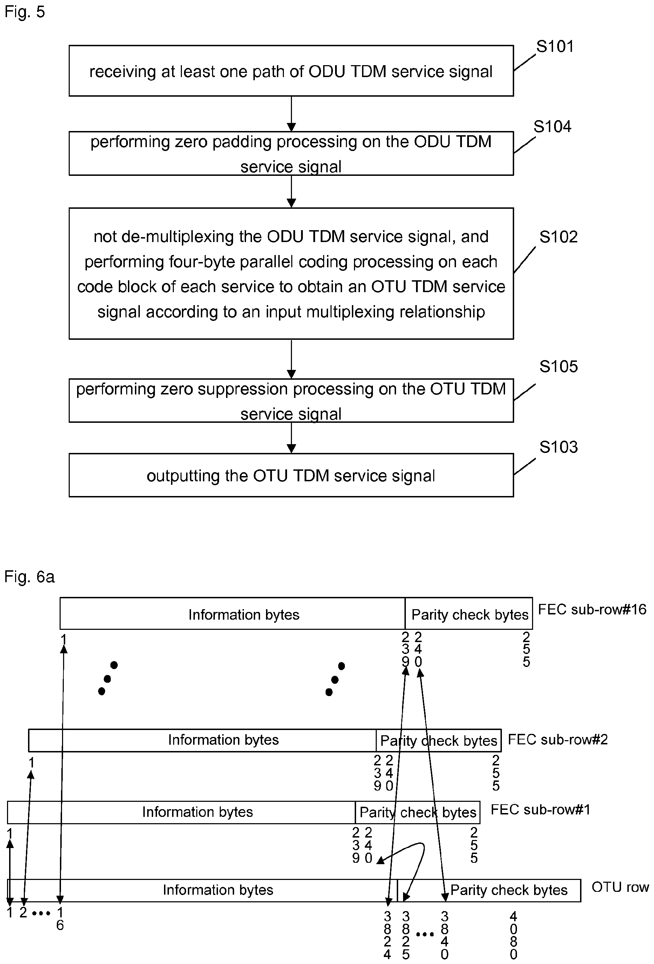

Fig. 5 is a second flowchart of a TDM-based FEC coding method according to an embodiment of the disclosure, and as shown in Fig. 5, on the basis of the first embodiment, before Step 102, the method further includes:
Step 104: zero padding processing is performed on the ODU TDM service signal.

Before Step 102, the method further includes:
Step 105: zero suppression processing is performed on the OTU TDM service signal.

A difference between the embodiment and the abovementioned embodiment is that the data to be coded is subjected to zero padding processing before the data is transmitted into the coder and subjected to interleaving processing, and correspondingly, before the coded OTU TDM service signal is output, the OTU TDM service signal is subjected to zero suppression processing. Therefore, data processing accuracy is ensured, and coding efficiency is further improved. The others of the embodiment are the same as those of the first embodiment.

According to the embodiment, by the processes of zero padding, interleaving, parallel coding, de-interleaving, zero suppression and the like, parallel coding including parts of TDM control, coding matrix operation, coding iteration calculation, data temporary storage and the like, multiple TDM input services are coded by virtue of the coding circuit, and an intermediate coding result of each service is temporarily stored, the check information is transferred into check registers for storage after coding is finished, an intermediate register is cleared, and the whole process is implemented under the restriction of a controller, in this way, the multiple paths of services are coded.

Fig. 6a is an interleaving diagram of 16 code blocks in an OTU frame structure according to an embodiment of the disclosure, and a basic principle for TDM-based parallel coding in the embodiment is described below on the premise of the OTU frame structure in Fig. 6a and an RS coding manner RS (255, 239) specified in appendix A of G.709 by taking the condition that a service A, a service B and a service C are TDM input service signals as an example.

A four-byte RS parallel coder matrix parameter shown in Fig. 3a and the coder parameter calculation formula shown in formula (1) and deduced according to the finite field generation polynomial are adopted. Meanwhile, the data registration circuit diagram, shown in Fig. 3b, of the four-byte RS parallel coder is adopted.

In Fig. 3b, the OTU frame structure includes 4,080 columns in each row, information to be coded occupying 3,824 columns and including 16 code blocks, and each code block being coded in 239 clock cycles if the serial coding manner is adopted, while being coded in only 60 clock cycles if the four-byte parallel coding manner according to the embodiment is adopted. Totally 240 columns are processed by the 60 cycles, and is one column more than those columns processed by the 239 cycles, thus zero can be padded at the beginning of each row.

In the embodiment, when a processing bit width is 512, the zero padding of the input data is finished at a starting position of each row: the 0th cycle, the 64th cycle, the 128th cycle and the 192nd cycle; and during coding output, each row has four pieces of cycle check information, and corresponding cycles are shown in Fig. 3b: the first row corresponds to 60th-63rd cycles, the second row corresponds to 124th-127th cycles, the third row corresponds to 188th-192nd cycles, and the fourth row corresponds to 251st-255th cycles. After the coding process is finished, zero padding information at corresponding positions is required to be removed to finish output service data registration, the data of each row is connected end to end, and a front part of the zero-suppressed second row is connected to a tail part of the zero-suppressed first row. The other rows are processed by the same method.

Fig. 3c is a structure diagram of an operation part of a four-byte RS parallel coder according to an embodiment of the disclosure. As shown in Fig. 3c, Ui (i=0, 1, 2, 3) is input parallel four-byte information to be coded, and R0-R15 are remainder registers, configured to store values obtained by coding operation processes, wherein U0=il_encode_i[7:0], U1=il_encode_i[15:8], U2=il_encode_i[23:16], and U3=il_encode_i[31:24].

Fig. 3b is a data registration circuit diagram of a four-byte RS parallel coder according to an embodiment of the disclosure. In the embodiment, multiple paths of TDM input service data are subjected to the direct coding of the coding circuit, besides four-byte parallel coding.

In the embodiment, thee paths of input services A, B and C are taken as an example for description. The embodiment is implemented based on the OTU frame structure, as a result, the coder includes 16 sub-coders for parallel processing. Coding output does not change the input multiplexing relationship, therefore, the service data and check information output are transmitted and coordinated between the 16 sub-coders and the cache circuits through control information.

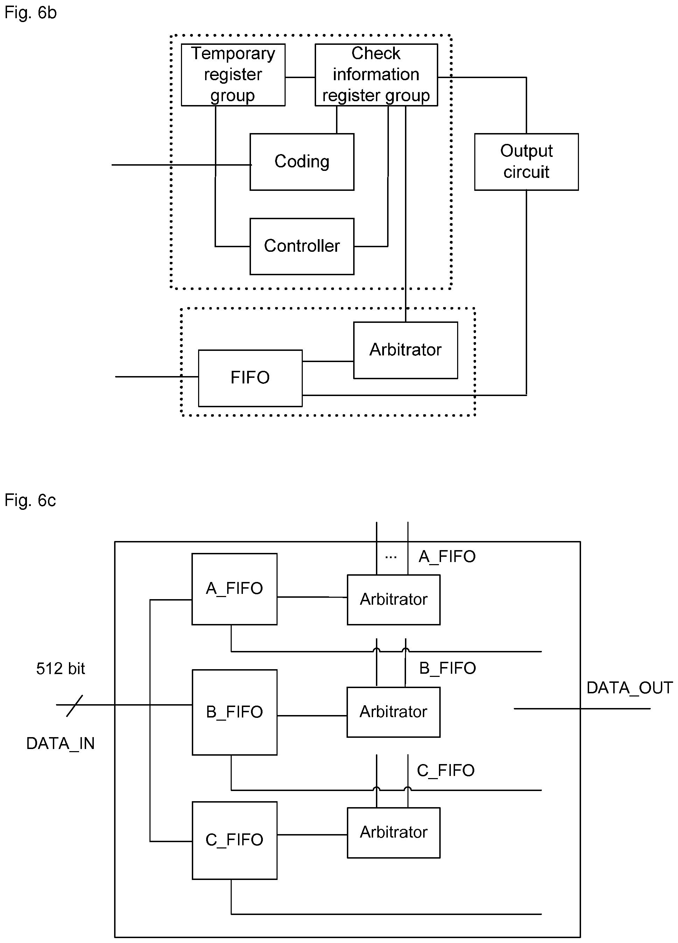

Fig. 6b is an inner structure diagram of a TDM sub-coder according to an embodiment of the disclosure. As shown in Fig. 6b, a temporary register group caches R0-R15 of each input service of which the coding process has yet not been finished, a check register group caches R0-R15 of each service of which the coding process has been finished, the coding result of each service after coding is transferred into check registers, and the process is implemented under the control of the controller.

Meanwhile, the check register group transmits an FEC information valid signal cached by a current check register to the FIFO circuit under the control of the controller. For the same service, when FEC check information is not completely output, data is preferably read from the registers for output; and when the FEC check information is completely output, the data is read from the FIFO circuit for output. The TDM relationship during service input is kept unchanged in a data output process.

The three services A, B and C are taken as examples, the controller controls operation processes of the three services through sub-controllers respectively. It is supposed that the service A is currently operated and the service B is required to be operated in the next cycle, the sub-controller for the service A judges whether a coding process is ended or not, transfers a coding result into registers corresponding to a check information register group of the service A for storage, otherwise stores an intermediate operation result of the service A into registers corresponding to the service A in the cache register group, and simultaneously operates the service B.

The service C is input in the third cycle, and then the sub-controller judges whether a coding process of the service B is ended or not, transfers a coding result into registers corresponding to the service B in a check information register group for storage, otherwise stores an intermediate operation result of the service B into registers corresponding to the service B in the cache register group, and simultaneously operates the service C.

Fig. 6c is a structure diagram of a FIFO circuit of a TDM sub-coder according to an embodiment of the disclosure. As shown in Fig. 6c, the services A, B and C are separately stored, and during output, A_FEC\B_FEC\C_FEC information from the coding circuit is arbitrated, signals transmitted by the 16 sub-coders should be consistent, and if the signals transmitted by the 16 sub-coders are inconsistent, coding error information is transmitted.

The condition that A_FEC is valid is taken as an example, and when the level is valid and a TDM output condition of the service A is met, that is, A_Valid is a high level, an output circuit extracts check information of the service A from the check register group of the sub-coders of the service A for output; and when A_FEC is invalid, the data output is read from A_FIFO. A multipath switch selects the corresponding service for output according to an output TDM relationship.

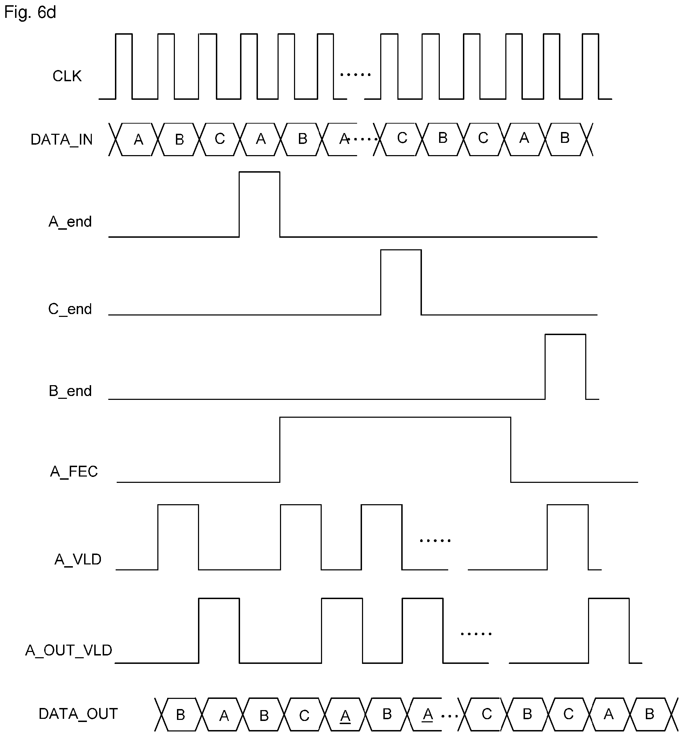

Fig. 6d is an illustration diagram of a working time sequence of a TDM sub-coder according to an embodiment of the disclosure. As shown in Fig. 6d, when the coding process of the service A is ended, an A_end pulse is valid, which indicates that the current coding of the service A is ended, and coded information is transferred into the check register group from the temporary register group for caching. Meanwhile, the controller transmits an A_FEC valid signal, which indicates that the check information of the service A is to be output. In the embodiment, A_FEC is set to high level, which indicates that there are four pieces of cycle check information of the service to be output in the register group. According to the input service multiplexing relationship, when the service A is output, A_VLD is valid; and when the level is valid and A_FEC is valid, the incompletely output check information of the service A is extracted from the check information register group. When the check information is completely output, A_FEC gets invalid, and when A_VLD is valid, data is read from A_FIFO for output. The services B and C are processed in the same way. In Fig. 6d, A_OUT_VALID refers to a finally output A service valid signal; and DATA_OUT is A service data output, and an underlined letter A indicates the check information read from the check information register.

Compared with the related art, the embodiments of the disclosure has advantages as follows:

(1) for the multiplexing data processing of multiple services, processing such as data collection before coding and output smoothing after coding is not required, coding operation can be directly performed according to an input service multiplexing characteristic, the same set of coding circuit is multiplexed by each input service, and compared with a manner that each service corresponds to a group of coders, such a manner has the advantages that coding circuit resource consumption is greatly reduced, and circuit power consumption is lowered;

(2) the apparatus for implementing the method according to the embodiment of the disclosure is extensible. When the number of input services increases, the processing circuit can be automatically adapted to a preceding transmission bandwidth, and when the current paths of the services increases by a path of service, only a group of registers or cache circuits is added to the corresponding circuit, thereby reducing required resource consumption;

(3) an OTU frame format specified in protocol G.709 is taken as an example, only one code word can be processed by each clock if an RS serial coding method shown in Fig. 1 in the related art is adopted, and at least four code words can be processed by each clock if a parallel coding method according to the embodiment of the disclosure is adopted, in this way, coding efficiency is improved by at least three times;

(4) an OTU frame is taken as an example, the data throughput of the RS serial coding method in the related art under a 240MHz clock is 1.92Gbps, and the throughput of a double-code word parallel coding manner is 61.44Gbps. The data throughput of the parallel coding method according to the embodiment of the disclosure is 122.88Gbps, thus the data throughput is further increased, and the parallel coding method is applied to high-speed network service transmission processing; and

(5) the mixed input of various types of services can simultaneously support the coding operation of each mixed service.

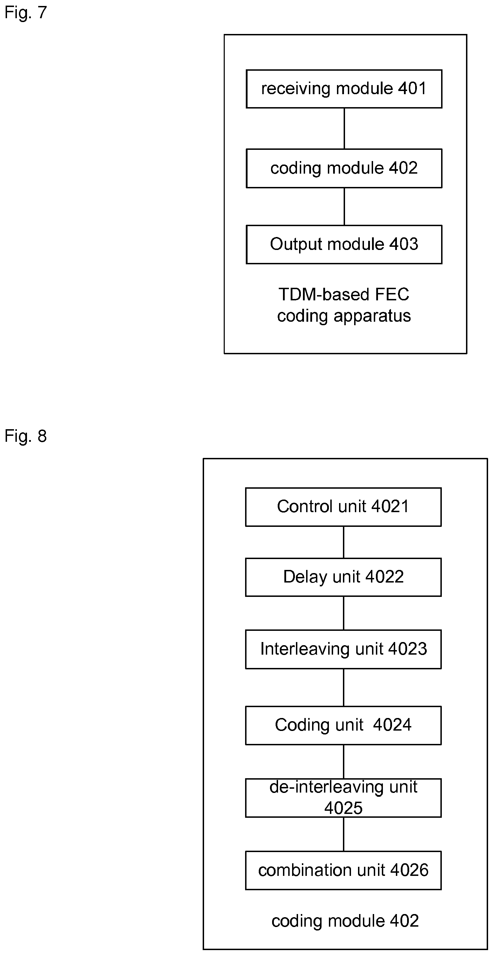

Fig. 7 is a first structure diagram of a TDM-based FEC coding apparatus according to an embodiment of the disclosure, and as shown in Fig. 7, the apparatus includes a receiving module 401, a coding module 402 and an output module 403, wherein:

the receiving module 401 is configured to receive at least one path of ODU TDM service signal;

the coding module 402 is configured to not de-multiplex the ODU TDM service signal, and perform four-byte parallel coding processing on each code block of each service to obtain an OTU TDM service signal according to an input multiplexing relationship; and

the output module 403 is configured to output the OTU TDM service signal.

The received ODU TDM service signal (called service signal hereinafter for short) may be one-path signals or multi-path signals. If multiple paths of service signals are received, types of the multiple paths of service signals may be the same, or partially the same or completely different, and when the multiple paths of service signals are processed, subsequent processing is sequentially performed according to clock cycles set by a system.

In the embodiment, the ODU TDM service signal may specifically be a 512-bit TDM service signal. During subsequent coding processing, the 512-bit TDM service signal is divided into 16 paths, and each path is subjected to four-byte parallel coding processing.

The path of 512-bit TDM service signal received by the receiving module 401 is taken as an example, and in the embodiment, the four-byte parallel RS coding of the 512-bit TDM service signal can be implemented.

During a practical application, the receiving module 401, the coding module 402 and the output module 403 may all be implemented by a Central Processing Unit (CPU), Digital Signal Processor (DSP) or Field Programmable Gate Array (FPGA) in the TDM-based FEC coding apparatus.

Fig. 3a is a matrix diagram of a four-byte RS parallel coder according to the embodiment. As shown in Fig. 3a, the matrix is also called a parameter matrix, and for an RS (255, 239), it is necessary to take 239 clock cycles to finish coding to obtain check information if a serial coding manner is adopted; while only 60 clock cycles are needed if a four-byte parallel coding processing manner is adopted, and accordingly, the coding efficiency is improved by four times.

During processing, the coding module 402 divides the received 512-bit TDM service signal into two paths of data; and the first path of data is transmitted into a FIFO circuit, and the second path of data is configured for the calculation of coded information as operational data, and is transmitted into a coder for four-byte parallel coding processing.

The path of data transmitted into the FIFO circuit is configured as original data, and is subjected to delaying processing to obtain a delayed ODU TDM service signal; and the delaying processing through the FIFO aims to keep the path of data aligned with the check information output by the coder in time sequence.

Before the second path of data is transmitted into the coder, the second path of data is required to be interleaved, and the interleaved data is transmitted into the coder and subjected to four-byte parallel coding processing to obtain coded check information; and the coded check information is de-interleaved.

Finally, the de-interleaved check information and the delayed ODU TDM service signal form the OTU TDM service signal for output by the output module 403.

In a coding processing process, a preset four-byte RS parallel coding iterative formula is adopted in the coder, and is specifically shown as formula (1).

Formula (1) is a coder parameter calculation formula deduced according to a finite field generation polynomial, the formula determines the operation complexity of a finite field algorithm, and if the operation complexity is higher, required resource cost is higher.

In addition, Fig. 3b is a data registration circuit diagram of a four-byte RS parallel coder according to the embodiment, and as shown in Fig. 3b, an OTU frame structure includes 4,080 columns in each row, information to be coded occupying 3,824 columns and including 16 code blocks, and each code block being coded in 239 clock cycles if the serial coding manner is adopted, and being coded in only 60 clock cycles if the four-byte parallel coding manner according to the embodiment is adopted. Totally 240 columns are processed by the 60 cycles, and is one column more than the columns processed by the 239 cycles, therefore, zero can be padded at the beginning of each row during specific coding processing, that is, the information to be coded can also be subjected to zero padding processing before the information to be coded is interleaved, and then corresponding zero suppression processing is required during the subsequent coding processing of the information to be coded in the coder; and the zero padding processing of the information to be coded can be avoided before the information to be coded is interleaved, and then corresponding zero suppression processing is not required during the subsequent coding processing of the information to be coded in the coder.

The structure of the four-byte RS parallel coder adopted in the embodiment is shown in Fig. 3c.

The structure of a logic module of the four-byte RS parallel coder adopted in the embodiment is shown in Fig. 3d.

Fig. 8 is a structure diagram of a coding module 402 of a TDM-based FEC coding apparatus according to an embodiment of the disclosure. As shown in Fig. 8, with the condition that an ODU TDM service signal is a 512-bit TDM service signal as an example, the coding module 402 includes: a control unit 4021, a delay unit 4022, an interleaving unit 4023, a coding unit 4024, a de-interleaving unit 4025 and a combination unit 4026, wherein:

the control unit 4021 is configured to control the ODU TDM service signal to be divided into two paths of data, wherein the first path of data is transmitted into a FIFO circuit, and the second path of data is configured for the calculation of coded information as operational data;

the delay unit 4022 is configured to perform delaying processing on the first path of data to obtain a delayed ODU TDM service signal by virtue of the FIFO circuit;

the interleaving unit 4023 is configured to perform interleaving processing on the second path of data;

the coding unit 4024 is configured to transmit the interleaved data into a coder, and perform four-byte parallel coding processing to obtain coded check information;

the de-interleaving unit 4025 is configured to perform de-interleaving processing on the coded check information; and

the combination unit 4026 is configured to form an OTU TDM service signal by virtue of the de-interleaved check information and the delayed ODU TDM service signal.

Preferably, with the received path of 512-bit TDM service signal as an example, the coding unit 4024 is further configured to transmit the interleaved data into 16 sub-coders respectively; to perform four-byte data parallel coding in each sub-coder; and to, after coding, if check information valid signals transmitted by the 16 sub-coders are consistent and meet an output condition of a current service, extract the check information of the service from a check register group of the sub-coders of the current service for output.

Preferably, when TDM service signals of multiple paths of ODU services are sequentially received according to preset clock cycles, the coding unit 4024 is further configured to, in a current clock cycle, transmit the interleaved data of the current service into the 16 sub-coders respectively; to perform four-byte data parallel coding in each sub-coder; to, when the next clock cycle comes, judge whether a coding process of the current service is ended or not, and to transfer a coding result of the current service into the check register group of the current service if the coding process of the current service is ended, otherwise, to store an intermediate result of data operation of the current service into a cache register group of the current service, and continue coding operation when the next clock cycle of the current service comes; to perform operation on the next service; and to, for each path of ODU TDM service signal, after coding is finished, if the check information valid signals transmitted by the 16 sub-coders are consistent and meet the output condition of the current service, extract the check information of the service from the check register group of the current service for output.

Compared with the related art, the embodiment has the advantages that by the solution, single-service and multi-service RS coding processes can be implemented with low resource consumption, resources can be more remarkably saved if there are more multiplexing services, and the static power consumption of a chip is also lowered; in addition, the coding processing in the embodiment has the characteristic of high data throughput, the data throughput is 64 times that of a conventional coder, and network data transmission processing capability is improved; the number of the clock cycles required by coding is reduced to 1/4 of that of a serial coder; and when the number of the multiplexing services increases, the coding circuit is easy to expand, the concern about insufficient processing bandwidth is eliminated, and the resource cost is extremely low.

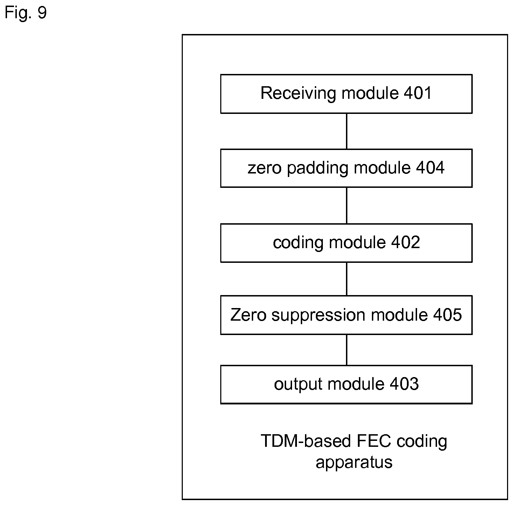

Fig. 9 is a second structure diagram of a TDM-based FEC coding apparatus according to an embodiment of the disclosure, and as shown in Fig. 9, based on the first embodiment, the FEC coding apparatus further includes:

a zero padding module 404 configured to, before the four-byte parallel coding processing of the ODU TDM service signal, perform zero padding processing on the ODU TDM service signal; and

a zero suppression module 405 configured to, before the output of the OTU TDM service signal, perform zero suppression processing on the OTU TDM service signal.

During the practical application, the receiving module 401, the coding module 402, the output module 403, the zero padding module 404 and the zero suppression module 405 may all be implemented by the CPU, DSP or FPGA in the TDM-based FEC coding apparatus.

A difference between the embodiment and the abovementioned embodiment is that the data to be coded is subjected to zero padding processing before the data is transmitted into the coder and subjected to interleaving processing, and correspondingly, before the coded OTU TDM service signal is output, the OTU TDM service signal is subjected to zero suppression processing. Therefore, data processing accuracy is ensured, and coding efficiency is further improved. The others of the embodiment are the same as those of the first embodiment.

According to the embodiment, by zero padding, interleaving, parallel coding, de-interleaving, zero suppression and the like, parallel coding including parts of TDM control, coding matrix operation, coding iteration calculation, data temporary storage and the like, multiple TDM input services are coded by virtue of the coding circuit, an intermediate coding result of each service is temporarily stored, the check information is transferred into check registers for storage after coding, an intermediate register is cleared, and the whole process is implemented under the restriction of a controller, so that the multiple paths of services are coded.

According to the embodiment, a basic principle for TDM-based parallel coding in the embodiment is described below with reference to the method embodiments on the premise of the OTU frame structure in Fig. 6a and an RS coding manner RS (255, 239) specified in appendix A of G.709 by taking the condition that a service A, a service B and a service C are TDM input service signals as an example, and will not be repeated here.

Compared with the prior art, the embodiment of the disclosure has advantages as follows:

(1) for the multiplexing data processing of multiple services, processing such as data collection before coding and output smoothing after coding is not required, coding operation can be directly performed according to an input service multiplexing characteristic, the same set of coding circuit is multiplexed by each input service, and compared with a manner that each service corresponds to a group of coders, such a manner has the advantages that coding circuit resource consumption is greatly reduced, and circuit power consumption is lowered;

(2) the FEC coding apparatus according to the embodiment of the disclosure is extensible. When the number of input services increases, the processing circuit can be automatically adapted to a preceding transmission bandwidth, and when the current paths of the services increases by a path of service, only a group of registers or cache circuits is added to the corresponding circuit, so that required resource consumption is low;

(3) an OTU frame format specified in protocol G.709 is taken as an example, only one code word can be processed by each clock if an RS serial coding method shown in Fig. 1 in the related art is adopted, and at least four code words can be processed by each clock if a parallel coding method according to the embodiment of the disclosure is adopted, so that coding efficiency is improved by at least three times;

(4) an OTU frame is taken as an example, the data throughput of the RS serial coding method in the related art under a 240MHz clock is 1.92Gbps, and the throughput of a double-code word parallel coding manner is 61.44Gbps. The data throughput of the parallel coding method according to the embodiment of the disclosure is 122.88Gbps, so that the data throughput is further increased, and the parallel coding method is applied to high-speed network service transmission processing; and

(5) the mixed input of various types of services can simultaneously support the coding operation of each mixed service.

The above is only the preferred embodiments of the disclosure and thus not intended to limit the scope of the disclosure.


**Claims**

1. A Time Division Multiplexing (TDM)-based Forward Error Correction (FEC) coding method for mixed services, comprising:

   receiving (S101) at least one path of Optical Data Unit (ODU) TDM service signal, comprising a multiplex of the mixed services;
   maintaining (S102) an input multiplexing relationship of the mixed services in the ODU TDM service signal, and performing four-byte parallel coding processing on each code block of each of the still multiplexed services to obtain an Optical Transfer Unit (OTU) TDM service signal, wherein intermediate coding results for each service are separately stored in remainder registers corresponding to each service; and
   outputting (S103) the OTU TDM service signal,
   wherein the ODU TDM service signal is a 512-bit TDM service signal,
   wherein the step of performing four-byte parallel coding processing on each code block of the ODU TDM service signal to obtain an OTU TDM service signal comprises:

      duplicating (S1021) the ODU TDM service signal into two paths of data, wherein a first path of data is transmitted into a First In First Out (FIFO) circuit, and a second path of data is taken as operational data to calculate coded information;
      performing (S1022) delaying processing on the first path of data to obtain a delayed ODU TDM service signal by virtue of the FIFO circuit;
      performing (S1023) interleaving processing on the second path of data;
      transmitting (S1024) the interleaved data into a coder, and performing four-byte parallel coding processing on the interleaved data to obtain coded check information;
      performing (S1025) de-interleaving processing on the coded check information; and
      forming (S1026) the OTU TDM service signal by combining the de-interleaved check information and the delayed ODU TDM service signal,

   wherein the step of transmitting (S1024) the interleaved data into a coder and performing four-byte parallel coding processing on the interleaved data to obtain coded check information comprises:

transmitting the interleaved data into 16 sub-coders respectively;

performing four-byte data parallel coding in each sub-coder; and

wherein for each service, a FEC valid signal indicates that the check information for the service is to be output, and when check information is completely output, the FEC valid signal gets invalid.

2. The TDM-based FEC coding method according to claim 1, wherein, when TDM service signals of multiple paths of ODU services are sequentially received according to preset clock cycles, the step of transmitting the interleaved data into a coder and performing four-byte parallel coding processing on the interleaved data to obtain coded check information comprises:

in a current clock cycle, transmitting interleaved data of a current service into 16 sub-coders respectively, and performing four-byte data parallel coding in each sub-coder;

when a next clock cycle comes, judging whether a coding process of the current service is ended or not; if ended, then transferring a coding result of the current service into a check register group of the current service;

if not ended, storing an intermediate result of data operation of the current service into a cache register group of the current service, and continuing coding operation when the next clock cycle of the current service comes; and performing operation on a next service.

3. The TDM-based FEC coding method according to claim 1 or 2, before the step of performing four-byte parallel coding on each code block of the ODU TDM service signal, the method further comprising:

performing (S104) zero padding processing on the ODU TDM service signal.

4. The TDM-based FEC coding method according to claim 3, before the step of outputting the OTU TDM service signal, the method further comprising:

performing (S105) zero suppression processing on the OTU TDM service signal.

5. A Time Division Multiplexing (TDM)-based Forward Error Correction (FEC) coding apparatus for mixed services, comprising:

a receiving module (401), configured to receive at least one path of Optical Data Unit (ODU) TDM service signal, comprising a multiplex of the mixed services;

a coding module (402), configured to maintain an input multiplexing relationship of the mixed services in the ODU TDM service signal, and perform four-byte parallel coding processing on each code block of each of the still multiplexed services to obtain an Optical Transfer Unit (OTU) TDM service signal, wherein intermediate coding results for each service are separately stored in remainder registers corresponding to each service; and

an output module (403), configured to output the OTU TDM service signal,

wherein the ODU TDM service signal is a 512-bit TDM service signal,

wherein the coding module (402) comprises:

a control unit (4021), configured to control the ODU TDM service signal to be duplicated into two paths of data, wherein a first path of data is transmitted into a First In First Out (FIFO) circuit, and a second path of data, as operational data, is configured to calculate coded information;

a delay unit (4022), configured to perform delaying processing on the first path of data to obtain a delayed ODU TDM service signal by virtue of the FIFO circuit;

an interleaving unit (4023), configured to perform interleaving processing on the second path of data;

a coding unit (4024), configured to transmit the interleaved data into a coder, and perform four-byte parallel coding processing on the interleaved data to obtain coded check information;

a de-interleaving unit (4025), configured to perform de-interleaving processing on the coded check information; and

a combination unit (4026), configured to form the OTU TDM service signal by combining the de-interleaved check information and the delayed ODU TDM service signal,

wherein the coding unit (402) is further configured to transmit the interleaved data into 16 sub-coders respectively; to perform four-byte data parallel coding in each sub-coder; and to, for each service, generate a FEC valid signal indicating that the check information for the service is to be output, and when check information is completely output, the FEC valid signal gets invalid.

6. The TDM-based FEC coding apparatus according to claim 5, wherein, when TDM service signals of multiple paths of ODU services are sequentially received according to preset clock cycles, the coding unit (402) is further configured to, in a current clock cycle, transmit interleaved data of a current service into 16 sub-coders respectively; to perform four-byte data parallel coding in each sub-coder; to, when a next clock cycle comes, judge whether a coding process of the current service is ended or not; if ended, to transfer a coding result of the current service into a check register group of the current service; if not ended, to store an intermediate result of data operation of the current service into a cache register group of the current service, and continue coding operation when the next clock cycle of the current service comes; and to perform operation on a next service.

7. The TDM-based FEC coding apparatus according to claim 5 or 6, further comprising:
a zero padding module (404) configured to, before the four-byte parallel coding processing is performed on the ODU TDM service signal, perform zero padding processing on the ODU TDM service signal.

8. The apparatus according to claim 7, further comprising:
a zero suppression module (405) configured to, before the OTU TDM service signal is output, perform zero suppression processing on the OTU TDM service signal.

**Patentansprüche**

1. Verfahren zur Vorwärtsfehlerkorrektur-Codierung (FEC-Codierung, Forward Error Correction) auf der Basis von Zeitmultiplex (TDM, Time Division Multiplexing) für gemischte Dienste, wobei das Verfahren Folgendes umfasst:

Empfangen (S101) wenigstens eines Pfads eines TDM-Dienstsignals optischer Datenkanaleinheiten (ODU, Optical Data Unit) (ODU-TDM-Dienstsignal), umfassend ein Multiplex der gemischten Dienste;
Beibehalten (S102) einer Eingangsmultiplexbeziehung der gemischten Dienste in dem ODU-TDM-Dienstsignal, und Durchführen einer Vier-Byte-Parallelcodierungsverarbeitung an jedem Codeblock jedes der noch gemultiplexten Dienste, um ein TDM-Dienstsignal optischer Übertragungseinheiten (OTU, Optical Transfer Unit) (OTU-TDM-Dienstsignal) zu erhalten, wobei Zwischencodierungsergebnisse für jeden Dienst separat in Rest-Registern gespeichert werden, die jedem Dienst entsprechen; und
Ausgeben (S103) des OTU-TDM-Dienstsignals,
wobei es sich bei dem ODU-TDM-Dienstsignal um ein 512-bit-TDM-Dienstsignal handelt,
wobei der Schritt der Duchführung einer Vier-Byte-Parallelcodierungsverarbeitung an jedem Codeblock des ODU-TDM-Dienstsignals, um ein OTU-TDM-Dienstsignal zu erhalten, Folgendes umfasst:

Duplizieren (S1021) des ODU-TDM-Dienstsignals in zwei Datenpfade, wobei ein erster Datenpfad an eine FIFO-Schaltung (First In First Out) übertragen wird und ein zweiter Datenpfad als Betriebsdaten verwendet wird, um codierte Informationen zu berechnen;
Durchführen (S1022) einer Verzögerungsverarbeitung an dem ersten Datenpfad, um aufgrund der FIFO-Schaltung ein verzögertes ODU-TDM-Dienstsignal zu erhalten;
Durchführen (S1023) einer Verschachtelungsverarbeitung an dem zweiten Datenpfad;
Übertragen (S1024) der verschachtelten Daten an einen Codierer und Durchführen einer Vier-Byte-Parallelcodierungsverarbeitung an den verschachtelten Daten, um codierte Prüfinformationen zu erhalten;
Durchführen (S1025) einer Entschachtelungsverarbeitung an den codierten Prüfinformationen; und
Bilden (S1026) des OTU-TDM-Dienstsignals durch Kombinieren der entschachtelten Prüfinformation und des verzögerten ODU-TDM-Dienstsignals,

wobei der Schritt des Übertragens (S1024) der verschachtelten Daten an einen Codierer und des Durchführens einer Vier-Byte-Parallelcodierungsverarbeitung an den verschachtelten Daten, um codierte Prüfinformationen zu erhalten, Folgendes umfasst:

Übertragen der verschachtelten Daten an jeweils 16 Subcodierer;
Durchführen einer Vier-Byte-Datenparallelcodierung in jedem Subcodierer; und
wobei für jeden Dienst ein FEC-gültiges Signal angibt, dass die Prüfinformationen für den Dienst ausgegeben werden sollen, und wenn die Prüfinformationen vollständig ausgegeben werden, das FEC-gültige Signal ungültig wird.

2. Verfahren zur FEC-Codierung auf der Basis von TDM nach Anspruch 1, wobei, wenn TDM-Dienstsignale mehrerer Pfade von ODU-Diensten gemäß voreingestellten Taktzyklen nacheinander empfangen werden, der Schritt des Übertragens der verschachtelten Daten an einen Codierer und des Durchführens einer Vier-Byte-Parallelcodierungsverarbeitung an den verschachtelten Daten, um codierte Prüfinformationen zu erhalten, Folgendes umfasst:

Übertragen verschachtelter Daten eines aktuellen Dienstes in einem aktuellen Taktzyklus an jeweils 16 Subcodierer, und Ausführen einer Vier-Byte-Datenparallelcodierung in jedem Subcodierer;

wenn ein nächster Taktzyklus kommt, Beurteilen, ob ein Codierungsprozess des aktuellen Dienstes beendet ist oder nicht; wenn beendet, Übertragen eines Codierungsergebnisses des aktuellen Dienstes in eine Prüfregistergruppe des aktuellen Dienstes; wenn nicht beendet, Speichern eines Zwischenergebnisses der Datenoperation des aktuellen Dienstes in einer Cache-Registergruppe des aktuellen Dienstes, und Fortsetzen des Codierungsvorgangs, wenn der nächste Taktzyklus des aktuellen Dienstes kommt; und

Durchführen des Vorgangs an einem nächsten Dienst.

3. Verfahren zur FEC-Codierung auf der Basis von TDM nach Anspruch 1 oder 2, wobei vor dem Schritt des Durchführens einer Vier-Byte-Parallelcodierung an jedem Codeblock des ODU-TDM-Dienstsignals das Verfahren weiterhin Folgendes umfasst:

Durchführen (S104) einer Null-Auffüllverarbeitung an dem ODU-TDM-Dienstsignal.

4. Verfahren zur FEC-Codierung auf der Basis von TDM nach Anspruch 3, wobei vor dem Schritt des Ausgebens des OTU-TDM-Dienstsignals das Verfahren weiterhin Folgendes umfasst:

Durchführen (S105) einer Null-Unterdrückungsverarbeitung an dem OTU-TDM-Dienstsignal.

5. Vorrichtung zur Vorwärtsfehlerkorrektur-Codierung (FEC-Codierung, Forward Error Correction) auf der Basis von Zeitmultiplex (TDM, Time Division Multiplexing) für gemischte Dienste, wobei die Vorrichtung Folgendes umfasst:

ein Empfangsmodul (401), das konfiguriert ist zum Empfangen wenigstens eines Pfads eines TDM-Dienstsignals optischer Datenkanaleinheiten (ODU, Optical Data Unit) (ODU-TDM-Dienstsignal), umfassend ein Multiplex der gemischten Dienste;

ein Codierungsmodul (402), das konfiguriert ist zum Beibehalten einer Eingangsmultiplexbeziehung der gemischten Dienste in dem ODU-TDM-Dienstsignal und zum Durchführen einer Vier-Byte-Parallelcodierungsverarbeitung an jedem Codeblock jedes der noch gemultiplexten Dienste, um ein TDM-Dienstsignal der optischen Übertragungseinheiten (OTU, Optical Transfer Unit) (OTU-TDM-Dienstsignal) zu erhalten, wobei Zwischencodierungsergebnisse für jeden Dienst separat in Rest-Registern gespeichert werden, die jedem Dienst entsprechen; und

ein Ausgabemodul (403) das konfiguriert ist zum Ausgeben des OTU-TDM-Dienstsignals,

wobei es sich bei dem ODU-TDM-Dienstsignal um ein 512-bit-TDM-Dienstsignal handelt,

wobei das Codierungsmodul (402) Folgendes umfasst:

eine Steuereinheit (4021), die konfiguriert ist zum Steuern des ODU-TDM-Dienstsignals, so dass es in zwei Datenpfade dupliziert wird, wobei ein erster Datenpfad an eine FIFO-Schaltung (First In First Out) übertragen wird und ein zweiter Datenpfad, der als Betriebsdaten verwendet wird, dazu konfiguriert ist, codierte Informationen zu berechnen;

eine Verzögerungseinheit (4022), die konfiguriert ist zum Durchführen einer Verzögerungsverarbeitung an dem ersten Datenpfad, um aufgrund der FIFO-Schaltung ein verzögertes ODU-TDM-Dienstsignal zu erhalten;

eine Verschachtelungseinheit (4023), die konfiguriert ist zum Durchführen einer Verschachtelungsverarbeitung an dem zweiten Datenpfad;

eine Codierungseinheit (4024), die konfiguriert ist zum Übertragen der verschachtelten Daten an einen Codierer und zum Durchführen einer Vier-Byte-Parallelcodierungsverarbeitung an den verschachtelten Daten, um codierte Prüfinformationen zu erhalten;

eine Entschachtelungseinheit (4025), die konfiguriert ist zum Durchführen einer Entschachtelungsverarbeitung an den codierten Prüfinformationen; und

eine Kombinationseinheit (4026), die konfiguriert ist zum Bilden des OTU-TDM-Dienstsignals durch Kombinieren der entschachtelten Prüfinformation und des verzögerten ODU-TDM-Dienstsignals,

wobei die Codiereinheit (402) weiterhin konfiguriert ist zum Übertragen der verschachtelten Daten an jeweils 16 Subcodierer; zum Durchführen einer Vier-Byte-Datenparallelcodierung in jedem Subcodierer; und zum Erzeugen eines FEC-gültigen Signals für jeden Dienst, welches Signal angibt, dass die Prüfinformationen für den Dienst ausgegeben werden sollen, und wenn die Prüfinformationen vollständig ausgegeben werden, das FEC-

**EP 2 903 167 B1**

gültige Signal ungültig wird.

6. Vorrichtung zur FEC-Codierung auf der Basis von TDM nach Anspruch 5, wobei, wenn TDM-Dienstsignale von mehreren Pfaden von ODU-Diensten nacheinander gemäß voreingestellten Taktzyklen empfangen werden, die Codiereinheit (402) weiterhin konfiguriert ist zum Übertragen von verschachtelte Daten eines aktuellen Diensts in einem aktuellen Taktzyklus an jeweils 16 Subcodierer; zum Durchführen einer Vier-Byte-Datenparallelcodierung in jedem Subcodierer; wenn ein nächster Taktzyklus kommt, zum Beurteilen, ob ein Codierungsprozess des aktuellen Dienstes beendet ist oder nicht; wenn beendet, zum Übertragen des Codierungsergebnisses des aktuellen Dienstes in eine Prüfregistergruppe des aktuellen Dienstes; wenn nicht beendet, zum Speichern eines Zwischenergebnisses der Datenoperation des aktuellen Dienstes in einer Cache-Registergruppe des aktuellen Dienstes, und zum Fortsetzen des Codierungsvorgangs, wenn der nächste Taktzyklus des aktuellen Dienstes kommt; und zum Durchführen des Vorgangs an einem nächsten Dienst.

7. Vorrichtung zur FEC-Codierung auf der Basis von TDM nach Anspruch 5 oder 6, die weiterhin Folgendes umfasst: ein Null-Auffüllmodul (404), das dazu konfiguriert ist, bevor die Vier-Byte-Parallelcodierungsverarbeitung an dem ODU-TDM-Dienstsignal durchgeführt wird, eine Null-Auffüllverarbeitung an dem ODU-TDM-Dienstsignal durchzuführen.

8. Vorrichtung nach Anspruch 7, die weiterhin Folgendes umfasst: ein Null-Unterdrückungsmodul (405), das dazu konfiguriert ist, bevor das OTU-TDM-Dienstsignal ausgegeben wird, eine Null-Unterdrückungsverarbeitung an dem OTU-TDM-Dienstsignal durchzuführen.

**Revendications**

1. Procédé de codage par correction d'erreurs directe (FEC, Forward Error Correction) reposant sur un multiplexage temporel (TDM, Time-Division Multiplexing) pour des services mixtes, comprenant :

la réception (S101) d'au moins un chemin d'un signal de service en TDM d'unités ODU (Optical Data Unit, unité de données de canal optique), comprenant un multiplexe des services mixtes,
le maintien (S102) d'une relation de multiplexage d'entrée des services mixtes dans le signal de service en TDM d'unités ODU, et la réalisation d'un traitement de codage en parallèle sur quatre octets sur chaque bloc de code de chacun des services encore multiplexés pour obtenir un signal de service en TDM d'unités OTU (Optical Transfer Unit, unité de transport de canal optique), des résultats de codage intermédiaires pour chaque service étant stockés séparément dans des registres de reste correspondant à chaque service, et
la production (S103) du signal de service en TDM d'unités OTU ;
ledit signal de service en TDM d'unités ODU étant un signal de service en TDM de 512 bits,
ladite étape de réalisation d'un traitement de codage en parallèle sur quatre octets sur chaque bloc de code du signal de service en TDM d'unités ODU pour obtenir un signal de service en TDM d'unités OTU comprend :

la duplication (S1021) du signal de service en TDM d'unités ODU en deux chemins de données, un premier chemin de données étant émis vers un circuit FIFO (First In First Out, premier entré, premier sorti), et un deuxième chemin de données servant de données opérationnelles pour calculer des informations codées,
la réalisation (S1022) d'un traitement de temporisation sur le premier chemin de données pour obtenir un signal de service en TDM d'unités ODU temporisé grâce au circuit FIFO,
la réalisation (S1023) d'un traitement d'entrelacement sur le deuxième chemin de données,
l'émission (S1024) des données entrelacées vers un codeur, et la réalisation d'un traitement de codage en parallèle sur quatre octets sur les données entrelacées pour obtenir des informations de vérification codées,
la réalisation (S1025) d'un traitement de désentrelacement sur les informations de vérification codées, et
la formation (S1026) du signal de service en TDM d'unités OTU en combinant les informations de vérification désentrelacées et le signal de service en TDM d'unités ODU temporisé ;

ladite étape d'émission (S1024) des données entrelacées vers un codeur et de réalisation d'un traitement de codage en parallèle sur quatre octets sur les données entrelacées pour obtenir des informations de vérification codées comprenant :

l'émission des données entrelacées vers 16 sous-codeurs respectifs,

la réalisation d'un codage en parallèle de données sur quatre octets dans chaque sous-codeur ; et pour chaque service, un signal de validité FEC indique que les informations de vérification pour le service doivent être produites, et lorsque les informations de vérification ont été totalement produites, le signal de validité FEC passe à invalide.

**2.** Procédé de codage par FEC reposant sur un multiplexage temporel selon la revendication 1, dans lequel, lorsque des signaux de service en TDM de multiples chemins de services d'unités ODU sont reçus séquentiellement selon des cycles d'horloge prédéfinis, l'étape d'émission des données entrelacées vers un codeur et de réalisation d'un traitement de codage en parallèle sur quatre octets sur les données entrelacées pour obtenir des informations de vérification codées comprend :

dans un cycle d'horloge en cours, l'émission des données entrelacées d'un service en cours vers 16 sous-codeurs respectifs, et la réalisation d'un codage en parallèle de données sur quatre octets dans chaque sous-codeur,

à la survenue d'un cycle d'horloge suivant, la détermination du fait qu'un processus de codage du service en cours est terminé ou non ; s'il est terminé, le résultat du codage du service en cours est transféré vers un groupe de registres de vérification du service en cours ; s'il n'est pas terminé, un résultat intermédiaire de l'exploitation de données du service en cours est stocké dans un groupe de registres de cache du service en cours, et l'opération de codage continue lorsque survient le cycle d'horloge suivant du service en cours, et

la réalisation de l'exploitation sur un service suivant.

**3.** Procédé de codage par FEC reposant sur un multiplexage temporel selon la revendication 1 ou 2, comprenant en outre, avant l'étape de réalisation d'un codage en parallèle sur quatre octets sur chaque bloc de code du signal de service en TDM d'unités ODU :
la réalisation (S104) d'un traitement d'ajout de zéros (zero padding) sur le signal de service en TDM d'unités ODU.

**4.** Procédé de codage par FEC reposant sur un multiplexage temporel selon la revendication 3, comprenant en outre, avant l'étape de production du signal de service en TDM d'unités OTU :
la réalisation (S105) d'un traitement de suppression de zéros (zero suppression) sur le signal de service en TDM d'unités OTU.

**5.** Dispositif de codage par correction d'erreurs directe (FEC, Forward Error Correction) reposant sur un multiplexage temporel (TDM, Time-Division Multiplexing) pour des services mixtes, comprenant :

un module de réception (401) conçu pour recevoir au moins un chemin d'un signal de service en TDM d'unités ODU (Optical Data Unit, unité de données de canal optique), comprenant un multiplexe des services mixtes,

un module de codage (402) conçu pour maintenir une relation de multiplexage d'entrée des services mixtes dans le signal de service en TDM d'unités ODU, et réaliser un traitement de codage en parallèle sur quatre octets sur chaque bloc de code de chacun des services encore multiplexés pour obtenir un signal de service en TDM d'unités OTU (Optical Transfer Unit, unité de transport de canal optique), des résultats de codage intermédiaires pour chaque service étant stockés séparément dans des registres de reste correspondant à chaque service, et

un module de production (403) conçu pour produire le signal de service en TDM d'unités OTU ;

ledit signal de service en TDM d'unités ODU étant un signal de service en TDM de 512 bits,

ledit module de codage (402) comprenant :

une unité de commande (4021) conçue pour commander la duplication du signal de service en TDM d'unités ODU en deux chemins de données, un premier chemin de données étant émis vers un circuit FIFO (First In First Out, premier entré, premier sorti), et un deuxième chemin de données servant de données opérationnelles étant conçu pour calculer des informations codées,

une unité de temporisation (4022) conçue pour réaliser un traitement de temporisation sur le premier chemin de données pour obtenir un signal de service en TDM d'unités ODU temporisé grâce au circuit FIFO,

une unité d'entrelacement (4023) conçue pour réaliser un traitement d'entrelacement sur le deuxième chemin de données,

une unité de codage (4024) conçue pour émettre les données entrelacées vers un codeur et pour réaliser un traitement de codage en parallèle sur quatre octets sur les données entrelacées pour obtenir des informations de vérification codées,

une unité de désentrelacement (4025) conçue pour réaliser un traitement de désentrelacement sur les informations de vérification codées, et

une unité de combinaison (4026) conçue pour former le signal de service en TDM d'unités OTU en combinant les informations de vérification désentrelacées et le signal de service en TDM d'unités ODU temporisé ;

ladite unité de codage (402) étant conçue en outre pour émettre les données entrelacées vers 16 sous-codeurs respectifs ; pour réaliser un codage en parallèle de données sur quatre octets dans chaque sous-codeur ; et pour générer, pour chaque service, un signal de validité FEC indiquant que les informations de vérification pour le service doivent être produites, et lorsque les informations de vérification ont été totalement produites, le signal de validité FEC passe à invalide.

6. Dispositif de codage par FEC reposant sur un multiplexage temporel selon la revendication 5, dans lequel, lorsque des signaux de service en TDM de multiples chemins de services d'unités ODU sont reçus séquentiellement selon des cycles d'horloge prédéfinis, l'unité de codage (402) est conçue en outre pour, dans un cycle d'horloge en cours, émettre les données entrelacées d'un service en cours vers 16 sous-codeurs respectifs ; pour réaliser un codage en parallèle de données sur quatre octets dans chaque sous-codeur ; pour déterminer, à la survenue d'un cycle d'horloge suivant, si un processus de codage du service en cours est terminé ou non ; s'il est terminé, pour transférer le résultat du codage du service en cours vers un groupe de registres de vérification du service en cours ; s'il n'est pas terminé, pour stocker un résultat intermédiaire de l'exploitation de données du service en cours dans un groupe de registres de cache du service en cours, et continuer l'opération de codage lorsque survient le cycle d'horloge suivant du service en cours ; et pour réaliser une exploitation sur un service suivant.

7. Dispositif de codage par FEC reposant sur un multiplexage temporel selon la revendication 5 ou 6, comprenant en outre :
un module d'ajout de zéros (404) conçu pour réaliser un traitement d'ajout de zéros (zero padding) sur le signal de service en TDM d'unités ODU, avant la réalisation du traitement de codage en parallèle sur quatre octets sur le signal de service en TDM d'unités ODU.

8. Dispositif selon la revendication 7, comprenant en outre :
un module de suppression de zéros (405) conçu pour réaliser un traitement de suppression de zéros (zero suppression) sur le signal de service en TDM d'unités OTU, avant l'émission du signal de service en TDM d'unités OTU.

Fig. 1

Fig. 2

| receiving at least one path of ODU TDM service signal | S101 |

| not de-multiplexing the ODU TDM service signal, and performing four-byte parallel coding processing on each code block of each service to obtain an OTU TDM service signal according to an input multiplexing relationship | S102 |

| outputting the OTU TDM service signal | S103 |

Fig. 3a

```
41  114 33  59  1  0  0  0  0  0  0  0  0  0  0  0
199 157 122 13  0  1  0  0  0  0  0  0  0  0  0  0
88  215 45  104 0  0  1  0  0  0  0  0  0  0  0  0
14  216 62  189 0  0  0  1  0  0  0  0  0  0  0  0
42  52  91  68  0  0  0  0  1  0  0  0  0  0  0  0
240 46  24  209 0  0  0  0  0  1  0  0  0  0  0  0
19  159 192 30  0  0  0  0  0  0  1  0  0  0  0  0
185 230 102 8   0  0  0  0  0  0  0  1  0  0  0  0
110 14  243 163 0  0  0  0  0  0  0  0  1  0  0  0
239 161 116 65  0  0  0  0  0  0  0  0  0  1  0  0
38  76  40  41  0  0  0  0  0  0  0  0  0  0  1  0
103 5   44  229 0  0  0  0  0  0  0  0  0  0  0  1
11  72  17  98  0  0  0  0  0  0  0  0  0  0  0  0
141 216 246 50  0  0  0  0  0  0  0  0  0  0  0  0
59  252 228 36  0  0  0  0  0  0  0  0  0  0  0  0
180 8   44  59  0  0  0  0  0  0  0  0  0  0  0  0
```

Fig. 3b

| 0 | 0 | 0 | • • • | 59 | 60 | • • • | 63 |

| 64 | 65 | 66 | • • • | 123 | 124 | • • • | 127 |

| 128 | 129 | 130 | • • • | 187 | 188 | • • • | 191 |

| 192 | 192 | 194 | • • • | 251 | 252 | • • • | 255 |

FEC bytes output

## Fig. 3c

Fig. 3d

Fig. 4

dividing the ODU TDM service signal into two paths of data, wherein the first path of data is transmitted into a FIFO circuit, and the second path of data is configured for the calculation of coded information as operational data — S1021

performing delaying processing on the first path of data to obtain a delayed ODU TDM service signal by virtue of the FIFO circuit — S1022

performing interleaving processing on the second path of data — S1023

transmitting the interleaved data into a coder, and performing four-byte parallel coding processing on the interleaved data to obtain coded check information — S1024

performing de-interleaving processing on the coded check information — S1025

forming the OTU TDM service signal by virtue of the de-interleaved check information and the delayed ODU TDM service signal — S1026

Fig. 5

receiving at least one path of ODU TDM service signal — S101

↓

performing zero padding processing on the ODU TDM service signal — S104

↓

not de-multiplexing the ODU TDM service signal, and performing four-byte parallel coding processing on each code block of each service to obtain an OTU TDM service signal according to an input multiplexing relationship — S102

↓

performing zero suppression processing on the OTU TDM service signal — S105

↓

outputting the OTU TDM service signal — S103

Fig. 6a

Fig. 6b

Fig. 6c

Fig. 6d

CLK

DATA_IN    A   B   C   A   B   A ····· C   B   C   A   B

A_end

C_end

B_end

A_FEC

A_VLD    ·····

A_OUT_VLD    ·····

DATA_OUT    B   A   B   C   A   B   A ··· C   B   C   A   B

Fig. 7

receiving module 401

coding module 402

Output module 403

TDM-based FEC
coding apparatus

Fig. 8

Control unit 4021

Delay unit 4022

Interleaving unit 4023

Coding unit 4024

de-interleaving unit
4025

combination unit 4026

coding module 402

Fig. 9

```
┌─────────────────────────────────────────┐
│                                          │
│    ┌──────────────────────────────┐      │
│    │    Receiving module 401       │      │
│    └──────────────────────────────┘      │
│                   │                       │
│    ┌──────────────────────────────┐      │
│    │   zero padding module 404     │      │
│    └──────────────────────────────┘      │
│                   │                       │
│    ┌──────────────────────────────┐      │
│    │      coding module 402        │      │
│    └──────────────────────────────┘      │
│                   │                       │
│    ┌──────────────────────────────┐      │
│    │  Zero suppression module 405  │      │
│    └──────────────────────────────┘      │
│                   │                       │
│    ┌──────────────────────────────┐      │
│    │      output module 403        │      │
│    └──────────────────────────────┘      │
│                                          │
│         TDM-based FEC coding              │
│              apparatus                    │
│                                          │
└─────────────────────────────────────────┘
```